# EUROPEAN PATENT APPLICATION

(11) **EP 2 061 094 A1**
(43) Date of publication of application: **20.05.2009**
(21) Application number: 07806615.6
(22) Date of filing: 03.09.2007
(51) Int. Cl.: H01L 31/10

(54) **LIGHT RECEIVING DEVICE, AND LIGHT RECEIVING DEVICE MANUFACTURING METHOD**

(30) Priority: 07.09.2006 JP 2006242328
(71) Applicant: Sony Corporation, Tokyo 108-0075 (JP)
(72) Inventor: FUJISAWA, Tomotaka, Tokyo 108-0075 (JP)
(74) Representative: Müller - Hoffmann & Partner
(86) International application number: PCT/JP2007/067142
(87) International publication number: WO 2008/029767

(57) **Abstract**

A light-receiving device includes a light-receiving part 11 that is formed in a semiconductor substrate 10 of a first conductivity type and has a first region 21 of a second conductivity type opposite to the first conductivity type, and a second region 22 of the second conductivity type that is formed on at least a part of the semiconductor substrate 10 around the light-receiving part 11 with the intermediary of an isolation region 23 of the first conductivity type and is electrically independent of the first region 21. The second region 22 is fixed to a potential independent of the first region 21. An aperture 42 of an interlayer insulating film 41 formed above the light-receiving part 11 is so formed as to range from an area above the first region 21 via an area above the isolation region 23 to an area above a part of the second region 22. Due to this configuration, a region of the same conductivity type as that of a photodiode is formed in at least a part of the periphery of the photodiode of the light-receiving part and carriers generated due to photons incident on the region side are swept out, to thereby allow enhancement in the light-reception sensitivity characteristic of the photodiode.

## Description

### Technical Field

The present invention relates to a light-receiving device and a method for manufacturing a light-receiving device.

### Background Art

For a light-receiving device (e.g. photodetector) supposed to be used for applications such as an optical pick-up in particular, a PIN (PN) photodiode employing a silicon (Si) -based substrate is frequently used because of simplicity of a manufacturing method thereof, superiority in terms of the cost, and easiness of incorporating thereof into an integrated circuit as a photodetector integrated circuit (PDIC). In step with recent demands for shorter wavelength and higher speed of optical discs, the same demands are becoming larger also for the photodetector.

The lowering of the light-reception sensitivity of the photodiode itself due to the recent trend toward the shorter wavelength of the optical discs has become a problem. Thus, the following devise for minimizing the lowering of the light-reception sensitivity has been implemented. Specifically, an antireflection film customized for an intended laser wavelength is formed as a thin film having a film thickness of several tens of nanometers on the surface of a light-receiving region to thereby suppress the reflectivity as much as possible.

Furthermore, because enhancement in the accuracy and functions of the optical system design is being advanced simultaneously, as one aspect of the performance the photodetector is expected to have, the photodetector needs to have both the following characteristics that seemingly contradict each other: the whole of the light-receiving region defined in the optical design keeps uniform light-reception sensitivity (device guaranteed value); and if light (e.g. stray light/reflected light of a laser) is incident on the outside of the light-receiving region, the light has no influence on the photoelectric conversion circuit (is not converted into an input signal).

As one example, conventionally the size of the photodetector in the optical design is often defined by an interconnect metal for light blocking (with a shape surrounding the outside of the light-receiving region). However, particularly in a process of a photodetector integrated circuit (PDIC) or the like, it is difficult to keep a uniform antireflection film structure for the entire area up to the edge (fringe) of the light-receiving region in particular in terms of e.g. the device processing technique.

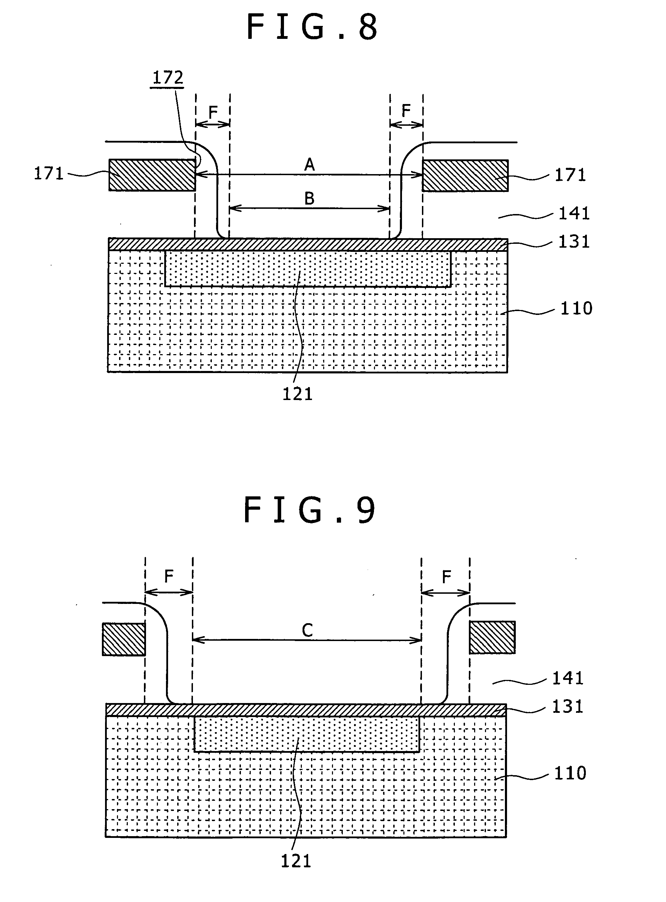

One example of the conventional techniques will be described below with reference to a sectional view of a general photodiode in FIG. 8.
As shown in FIG. 8, an N-type impurity region (cathode region) 121 is formed on a P-type substrate (anode) 110. In the present configuration, a light-blocking metal film 171 is so formed as to range to the inside of the cathode region 121, and an optical photodiode size A is defined by an aperture 172 formed in this light-blocking metal film 171. However, in the actual manufacturing method, an aperture needs to be formed in an interlayer insulating film 141 that is formed on an antireflection film 131 having a film thickness on the order of several tens of nanometers and has a film thickness in the range of about 1 µm to several micrometers, and the interlayer insulating film 141 is left in a fringe part F for processing reasons. This causes a problem that the optical photodiode size is decreased to a size B. Because the reflectivity of the fringe part F can not be controlled, a problem arises that the sensitivity is decreased to a value lower than the design value and the actual light-reception sensitivity itself becomes an unknown value (including variation among individuals).

Furthermore, as shown in a sectional view of FIG. 9, an optical photodiode size C is designed inside the left interlayer insulating film 141 in the fringe part F, and light incident on the outside thereof is not completely blocked but contributes to photoelectric conversion. Thus, the fundamental problem solution is not achieved.

Furthermore, even if, as shown in FIG. 9, the PN junction end of the cathode region 121 is formed inside the area in which the antireflection film 131 is uniform in order to solve the problem described with FIG. 8, light incident on the reflective substrate 110 (anode region) is also converted into carrier pairs and then the carriers reach the PN junction part (depletion layer) at a certain ratio so as to contribute to an effective current signal. Thus, this configuration does not lead to the fundamental problem solution.

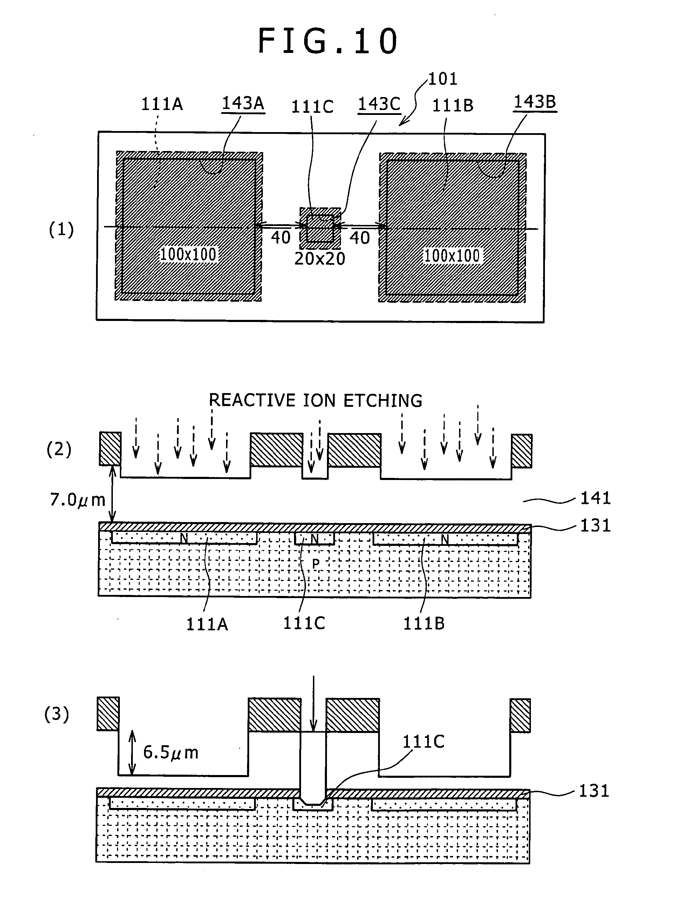

Moreover, for example, if plural photodetectors exist in one photodetector integrated circuit and an interlayer thereof is removed by using a dry etching technique such as reactive ion etching (RIE) and if the sizes of the photodiodes are greatly different from each other, the dependency of the etching rate on the size arises, which causes a possibility of the occurrence of a problem that etching to constant depth becomes impossible. For example, as shown in FIGS. 10(1) and 10(2), if one photodiode 111C having a size of 20 µm × 20 µm and two photodiodes 111A and 111B each having a size of 100 µm × 100 µm on both the sides of the photodiode 111C exist in the same photodetector integrated circuit 101 and if apertures are formed in the interlayer insulating film 141 by reactive ion etching, the etching rate of an aperture 143C for the photodiode 111C with the size of 20 µm × 20 µm is higher than that of apertures 143A and 143B for the photodiodes 111A and 111B. This will cause a possibility that the antireflection film 131 under the interlayer is also etched only in the aperture 143C.

In the photodetector integrated circuit, in step with advancing of the generation of the platform process thereof, the number of layers of the interlayer insulating film is increasing, and correspondingly the thickness of the interlayer insulating film is also increasing. The possibility that the above-described problem will become a more important issue in the future is high. A consideration will be made below about the case in which the 50 nm antireflection film (e.g. silicon nitride film) 131 exists under the interlayer insulating film (assumed to be totally 7 µm) 141 for example.

This consideration is based on an assumption of employing process design in which 6.5 µm of the 7 µm interlayer insulating film (assumed to be a silicon oxide film) 141 is etched by reactive ion etching and then only the remaining 0.5 nm oxide film is etched by solution etching based on a hydrofluoric acid to thereby form an aperture above the antireflection film 131. In this case, if the etching rate of the reactive ion etching for the size of 20 µm × 20 µm is 1.1 times that for the size of 100 µm × 100 µm, the equation 7.0 µm - (6.5 × 1.1) nm = - 0.15 µm is obtained, which indicates that the etching reaches the antireflection film 131 directly beneath the interlayer insulating film 141 as shown in FIG. 10(3). If the film thickness of the antireflection film 131 is 50 nm, this etching penetrates the antireflection film 131 and the surface of the photodiode 111C thereunder is also etched. Naturally, if the film thickness of the interlayer insulating film/etching variation in the reactive ion etching itself is taken into consideration, this problem will become more severe, so that this process design will become unviable.

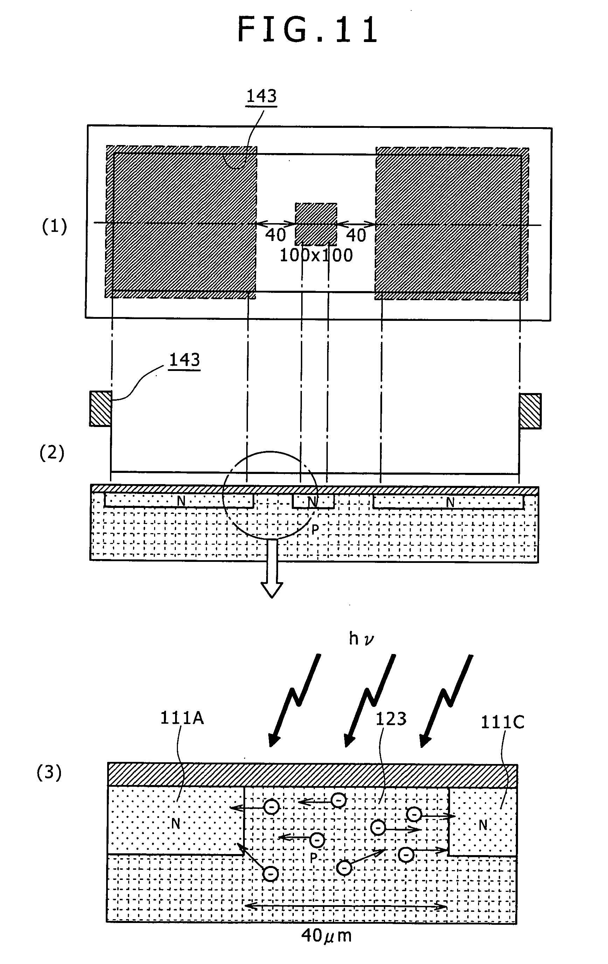

In contrast to the above description, the above-described problem in the process would be solved by opening the large aperture 143 wholly as shown in FIGS. 11(1) and 11(2). However, as described above, also in the present example, photons P injected into a large isolation region 123 whose width ranges up to 40 µm are not completely recombined in the isolation region 123 but a part thereof is captured into the photodiodes 111A and 111C on both the sides thereof as shown in FIG. 11(3). If the light incident on the isolation region 123 is added as an input signal, the photodiode characteristics typified by the noise characteristic and the frequency characteristic (speed) are significantly adversely affected.

Another technique is also disclosed. In the technique, a background-light capturing region of the same conductivity type as that of a light-receiving region is formed around the light-receiving region with the intermediary of at least an interval L, to thereby cause holes due to light incident on the outside of the light-receiving region to be captured by a depletion layer formed by the background-light capturing region so that the holes may not contribute to a photocurrent (refer to e.g. Japanese Patent Laid-open No. Hei 9-289333). However, a consideration about the above-described problem that arises in the formation of apertures is not disclosed therein.

### Disclosure of Invention

The problem to be solved is that light incident on an isolation region around a light-receiving region is not recombined in the isolation region but a part thereof is captured into the light-receiving region so as to be added as an input signal and thus significant adverse effect on the photodiode characteristics, such as the occurrence of noise and the deterioration of the frequency characteristic (speed), are caused.

A challenge of the present invention is to form a region of the same conductivity type as that of a photodiode on at least a part of the periphery of the photodiode of a light-receiving part and sweep out carriers generated due to photons incident on the region side to thereby allow enhancement in the light-reception sensitivity characteristic of the photodiode.

The present invention relating to claim 1 includes a light-receiving part that is formed in a semiconductor substrate of a first conductivity type and has a first region of a second conductivity type opposite to the first conductivity type, and a second region of the second conductivity type that is formed on at least a part of the semiconductor substrate around the light-receiving part with the intermediary of an isolation region of the first conductivity type and is electrically independent of the first region. The second region is fixed to a potential independent of the first region. An aperture of an insulating film formed above the light-receiving part is so formed as to range from an area above the first region via an area above the isolation region to an area above a part of the second region.

In the present invention relating to claim 1, the second region of the second conductivity type that is formed on at least a part of the semiconductor substrate around the light-receiving part with the intermediary of the isolation region of the first conductivity type and is electrically independent of the first region is provided. Furthermore, the second region is fixed to a potential independent of the first region. Thus, carriers generated due to photons incident on the second region side are swept out toward the fixed potential side. In addition, the aperture of the insulating film formed above the light-receiving part is so formed as to range from an area above the first region via an area above the isolation region to an area above a part of the second region. Therefore, the size of the first region is equivalent to the effective light-receiving region, and light incident on the periphery of the first region is swept out by the second region as described above and thus has no influence on the light-reception sensitivity of the first region.

The present invention relating to claim 9 includes the steps of forming, in a semiconductor substrate of a first conductivity type, a plurality of first light-receiving parts each having a first region of a second conductivity type opposite to the first conductivity type, and forming a second light-receiving part that is independent of and different from the plurality of light-receiving parts in the semiconductor substrate of at least one place between the first light-receiving parts, and forming a second region of the first conductivity type between the first light-receiving part and the second light-receiving part with the intermediary of an isolation region. The present invention relating to claim 9 further includes the steps of forming an antireflection film on the first light-receiving parts, the second light-receiving part, and regions that isolate the first light-receiving part and the second light-receiving part from each other, forming an insulating film on the antireflection film, and thereafter forming an aperture having the bottom at which the antireflection film is exposed in the insulating film above the first light-receiving parts and the second light-receiving part in a continuous manner, and fixing the second region to a potential independent of the first region.

In the present invention relating to claim 9, the aperture having the bottom at which the antireflection film is exposed is formed in the insulating film above the first light-receiving parts and the second light-receiving part in a continuous manner. This eliminates the occurrence of a trouble that the antireflection film on the second light-receiving part is polished and penetrated by etching. Thus, a uniform film thickness can be kept as the film thickness of the antireflection film on the respective light-receiving parts, and therefore the equal antireflection effect can be achieved for the respective light-receiving parts. Furthermore, the second region is formed for the first region with the intermediary of the isolation region and this second region is fixed to a potential independent of the first region. Thus, as described above, carriers generated due to photons incident on the second region side are swept out toward the fixed potential side because the second region is fixed to the potential independent of the first region.

### Brief Description of Drawings

[FIG. 1]

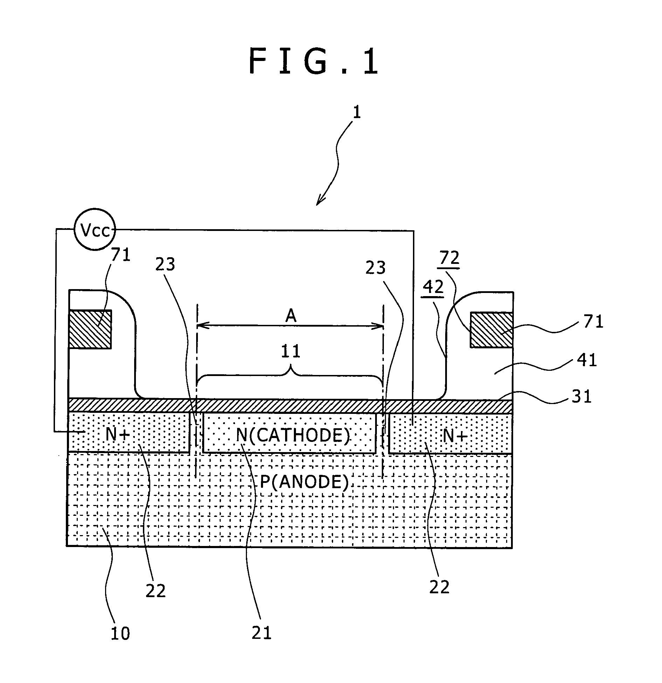

   FIG. 1 is a schematic configuration sectional view showing one embodiment (first embodiment example) relating to the light-receiving device according to the present invention.
[FIG. 2]

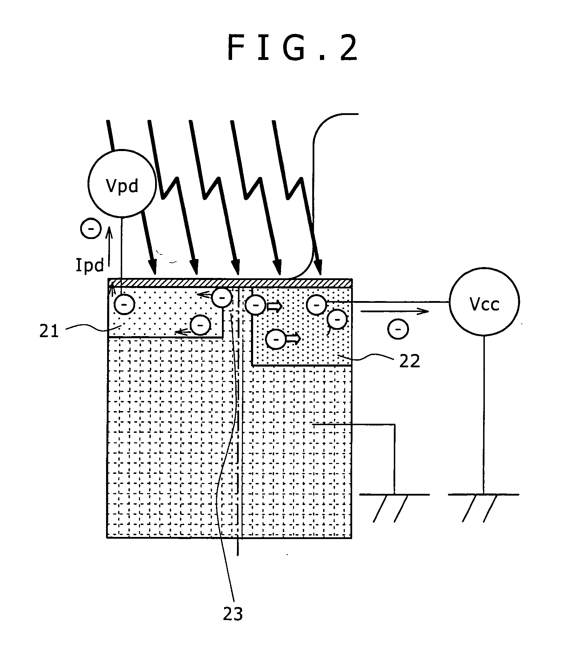

   FIG. 2 is an enlarged sectional view showing one embodiment (first embodiment example) relating to the light-receiving device according to the present invention.
[FIG. 3]

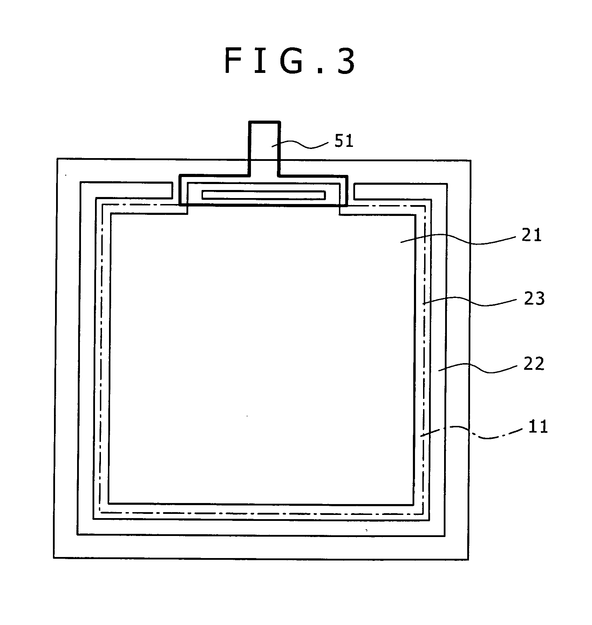

   FIG. 3 is a plan view showing one embodiment (second embodiment example) relating to the light-receiving device according to the present invention.
[FIG. 4]

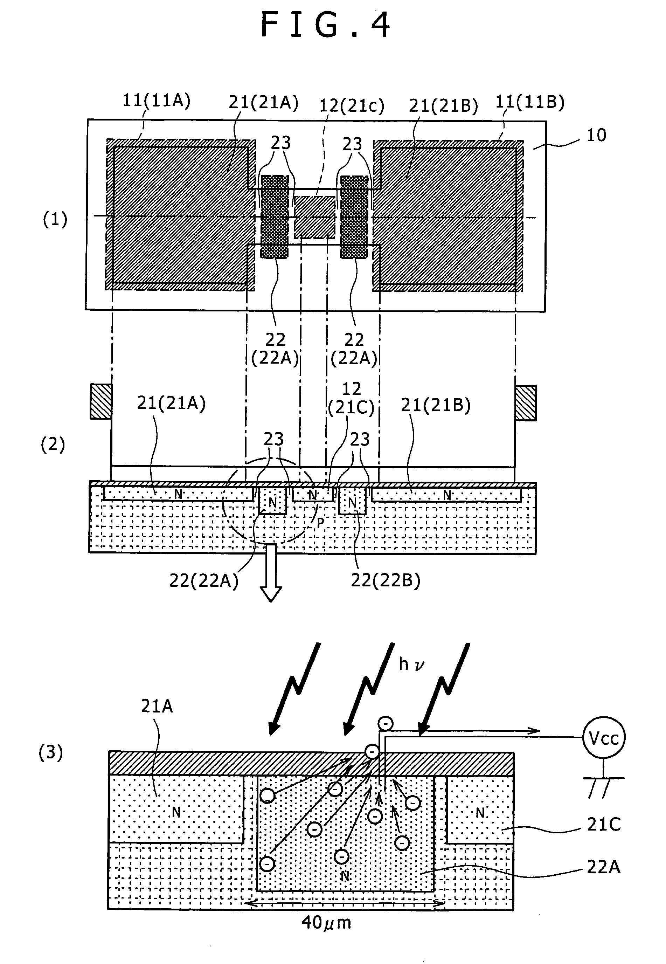

   FIG. 4 is plan view, sectional view, and enlarged schematic sectional view showing one embodiment (third embodiment example) relating to the light-receiving device according to the present invention.
[FIG. 5]

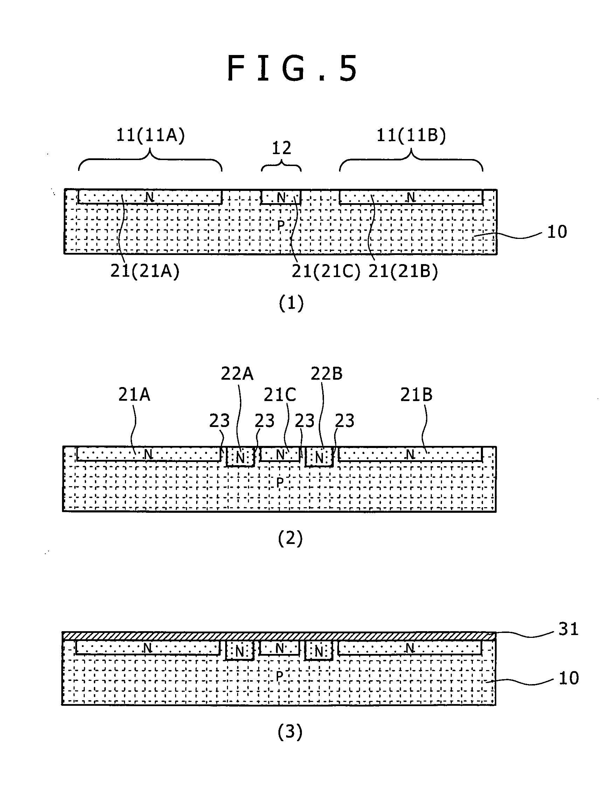

   FIG. 5 is manufacturing step diagrams showing one embodiment (embodiment example) relating to the method for manufacturing a light-receiving device according to the present invention.
[FIG. 6]

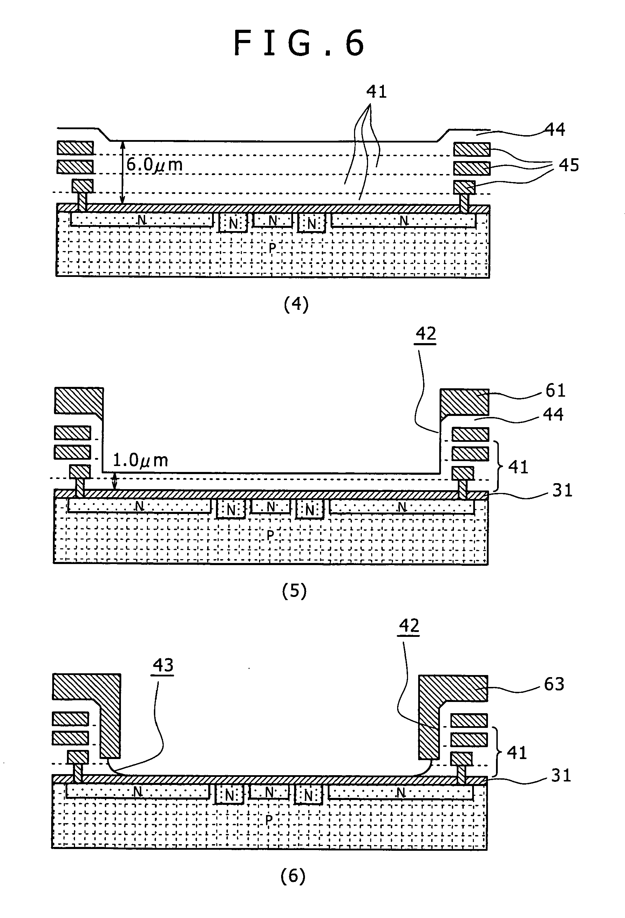

   FIG. 6 is manufacturing step diagrams showing one embodiment (embodiment example) relating to the method for manufacturing a light-receiving device according to the present invention.
[FIG. 7]

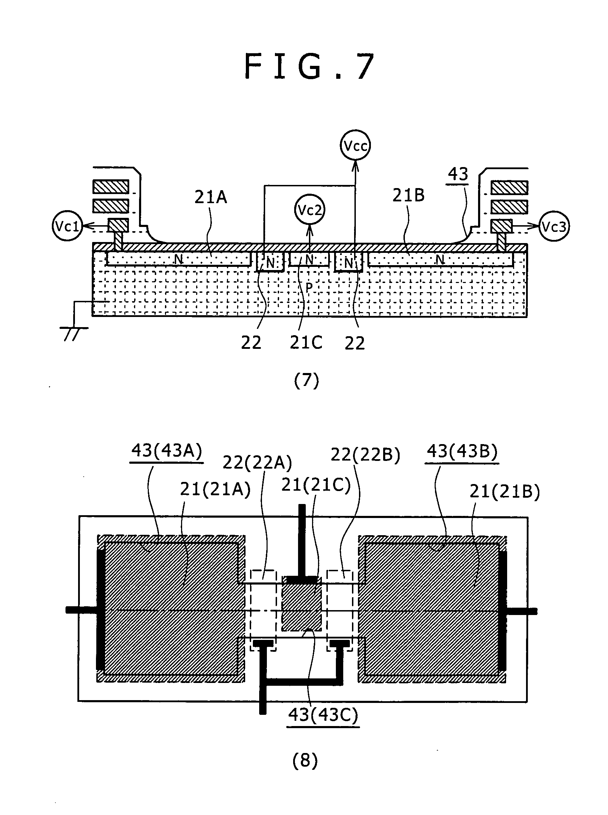

   FIG. 7 is manufacturing step diagrams showing one embodiment (embodiment example) relating to the method for manufacturing a light-receiving device according to the present invention.
[FIG. 8]
   FIG. 8 is a sectional view showing a general photodiode as one example of conventional techniques.
[FIG. 9]
   FIG. 9 is a diagram showing one problem of the photodiode of the conventional technique.
[FIG. 10]
   FIG. 10 is diagrams showing one problem in a manufacturing step of the conventional technique.
[FIG. 11]
   FIG. 11 is diagrams showing a problem in the conventional technique.

### Best Mode for Carrying Out the Invention

One embodiment (first embodiment example) relating to the light-receiving device according to the present invention will be described below with reference to a schematic configuration sectional view of FIG. 1 and an enlarged sectional view of FIG. 2.

As shown in FIG. 1, a light-receiving device 1 has the following configuration. Specifically, on a semiconductor substrate 10 of a first conductivity type (e.g. P-type) serving as the anode, a first region (cathode) 21 of a second conductivity type (e.g. N-type) in a photodiode serving as a light-receiving region is formed. The semiconductor substrate 10 is formed of e.g. a silicon substrate and the substrate concentration thereof is set to about 1 × 10¹⁴ cm⁻³. For example, the first region 21 has a junction depth xj = 0.6 µm and a concentration gradient in the depth direction from about 1 × 10²⁰ cm⁻³ as the surface concentration to about 1 × 10¹⁵ cm⁻³ in a grated manner.

In a fringe part of the first region 21, a second region 22 of the second conductivity type (N-type) is so provided as to be electrically independent of the first region 21 with the intermediary of an isolation region 23 of the first conductivity type (P-type), formed of the semiconductor substrate 10. The isolation region 23 is so formed as to have a width of e.g. about 2 µm and has e.g. a profile of a junction depth xj = 1.0 µm and a surface concentration of about 2 × 10²⁰ cm⁻³. It is desirable for the second region 22 to have a concentration profile with some extent of depth and concentration in consideration of decrease in the parasitic resistance, the lifetime of unnecessary carriers, and so on. However, no particular problem is caused also when the same impurity layer (profile) as that of the first region 21 (cathode) is used in view of facilitation of the process.

Furthermore, in this case, e.g. the center of the isolation region 23 is defined as the boundary that defines the size A of a light-receiving part (light-receiving region) 11 in the optical design. In the structure design of the light-receiving part 11, an aperture 42 of an interlayer insulating film 41 is so opened that an antireflection film 31 has a uniform film thickness in an area including the isolation region 23 and at least a part of the second region 22. The aperture 42 is so formed as to range from an area above the first region 21 via an area above the isolation region 23 to an area above a part of the second region 22. Furthermore, also for an aperture in a light-blocking film 71 formed in the interlayer insulating film 41, the aperture 42 is so formed as to range from an area above the first region 21 via an area above the isolation region 23 to an area above a part of the second region 22. Thus, the size of the first region is equivalent to the effective light-receiving region, and light incident on the periphery of the first region 21 will be swept out by the second region 21 as described later. Therefore, this light has no influence on the light-reception sensitivity of the first region.

As for electrical features, the second region 22 is fixed to a supply voltage Vcc. It is sufficient that the second region 22 has a fixed potential irrespective of Vcc in order to discharge unnecessary carriers. However, employing the highest potential is effective. It is desirable that at least the relationship Vpd (the potential of the first region 21) ≤ Vn (the potential of the second region) be satisfied so that the carriers can be surely removed.

Due to this configuration, as shown in FIG. 2, only the carriers generated due to the photons incident on the first region 21 side defined based on the P-type isolation region 23 as the boundary move toward the first region 21 as the cathode electrode of the photodiode so as to be counted as an electric signal arising from photoelectric conversion. In contrast, the carriers generated due to the photons incident on the second region 22 side defined based on the P-type isolation region 23 as the boundary are effectively swept out toward the Vcc side, and thus are not counted as an excess current signal in the first region 21 (cathode) side of the photodiode. Furthermore, the size of the first region 21 is equivalent to the size of the effective light-receiving region, which provides an advantage that a favorable light-reception sensitivity characteristic is achieved in terms of both the limit to the light-reception sensitivity with respect to the size of the light-receiving region in the optical design and anti-stray-light measures against light incident on the outside of the light-receiving region. In addition, the deterioration of the crosstalk characteristic due to the influence of light incident on the separation region can be prevented.

Next, one embodiment (second embodiment example) relating to the light-receiving device according to the present invention will be described below with reference to a plan view of FIG. 3.

It is ideal that the second region 22, which is formed for the first region 21 with the intermediary of the isolation region 23, be formed in the whole of the fringe part of the first region 21 of the photodiode, i.e. in the whole of the periphery of the first region 21, as shown in FIG. 3. However, in practice, a lead-out electrode 51 (e.g. metal interconnect) needs to be provided in the first region 21 serving as the cathode. Therefore, it is practical to provide the second region 22 in the periphery of the first region 21 except the formation area of the lead-out electrode 51 with the intermediary of the isolation region 23. The second region 22 is connected to Vcc.

As described above, the size of the light-receiving part 11 in the optical design is defined by the center of the isolation region 23. However, the center of the isolation region 23 does not necessarily need to be employed as the boundary but the proper position of the boundary serving as the actual border of the movement direction of carriers may be determined in consideration of the electric field gradient depending on the potential difference between Vd and Vcc, the concentration profiles of the first region 21 as the cathode and the second region 22, the concentration profile/width of the isolation region 23, and so on.

Next, one embodiment (third embodiment example) relating to the light-receiving device according to the present invention will be described below with reference to FIG. 4.

As shown in the layout plan view of FIG. 4(1) and the sectional view of FIG. 4(2), on a semiconductor substrate 10 of a first conductivity type (e.g. P-type) serving as the anode, first regions (cathode) 21 (21A) and 21 (21B) of a second conductivity type (e.g. N-type) in photodiodes serving as first light-receiving parts 11 (11A) and 11 (11B) are formed at intervals. The semiconductor substrate 10 is formed of e.g. a silicon substrate and the substrate concentration thereof is set to about 1 × 10¹⁴ cm⁻³. For example, the first region 21 has e.g. a junction depth xj = 0.6 µm and a concentration gradient in the depth direction from about 1 × 10²⁰ cm as the surface concentration to about 1 × 10¹⁵ cm⁻³ in a grated manner.

Between the first regions 21A and 21B, a first region 21C of a second light-receiving part 12 that is independent of and different from the first light-receiving parts 11A and 11B is formed. Furthermore, between the first region 21A and the second region 21C and between the first region 21B and the second region 21C, second regions 22 (22A) and 22 (22B) of the second conductivity type (N-type) are provided in the respective fringe parts of the first regions 21 with the intermediary of isolation regions 23 of the first conductivity type (P-type) in such a manner as to be electrically independent of the first regions 21. The isolation regions 23 are so formed as to have e.g. the minimum width in the design rule and have e.g. a profile of a junction depth xj = 1.0 µm and a surface concentration of about 2 × 10²⁰ cm⁻³.

Furthermore, by fixing the second regions 22 to an independent potential such as a supply potential or a reference potential, generated carriers can be extracted from the second regions 22 as the N-type regions. This makes it possible to avoid the influence on the original optical light-receiving region.

It is desirable for the second regions 22 to have a concentration profile with some extent of depth and concentration in consideration of decrease in the parasitic resistance, the lifetime of unnecessary carriers, and so on. However, no particular problem is caused also when the same impurity layer (profile) as that of the first regions 21 (cathode) is used in view of facilitation of the process.

As for electrical features, the second regions 22 are fixed to e.g. a supply voltage Vcc. It is sufficient that the second regions 22 have a fixed potential irrespective of Vcc in order to discharge unnecessary carriers. However, employing the highest potential is effective. It is desirable that at least the relationship Vpd (the potential of the first regions 21) ≤ Vn (the potential of the second regions 22) be satisfied so that the carriers can be surely cancelled.

Due to this configuration, as shown in the enlarged diagram of FIG. 4(3), the carriers generated due to the photons incident on e.g. the second region 22A between the first region 21A and the first region 21C are effectively absorbed toward the Vcc side, and thus are not counted as an excess current signal in the first region 21A of the photodiode.

Furthermore, the second light-receiving part 12 provided in the isolation regions 23 does not need to have high photoelectric conversion efficiency and may be an N-type layer with high concentration (and large depth according to need) in the sense of reducing the parasitic resistance.

Next, one embodiment (embodiment example) relating to the method for manufacturing a light-receiving device according to the present invention will be described below with reference to manufacturing step diagrams of FIGS. 5 to 7. In this description, a method for manufacturing the configuration of the above-described second embodiment example will be shown as one example.

As shown in FIG. 5(1), on the semiconductor substrate 10 of the first conductivity type (e.g. P-type) serving as the anode, the first regions (cathode) 21 (21A) and 21 (21B) of the second conductivity type (e.g. N-type) in the photodiodes serving as the first light-receiving parts 11 (11A) and 11 (11B) and the first region 21 (21C) of the second light-receiving part 12 between the first light-receiving parts 11A and 11B are formed at intervals. As the semiconductor substrate 10, e.g. a silicon substrate is used, and the substrate concentration thereof is set to about 3 × 10¹⁴ cm⁻³. The ion implantation condition is so set that the first regions 21 will have e.g. a junction depth Xj = 700 nm and a concentration of about 2 × 10²⁰ cm⁻³.

Subsequently, as shown in FIG. 5(2), on the semiconductor substrate 10 between the first region 21A and the first region 21C and between the first region 21B and the first region 21C, the second regions 22 (22A) and 22 (22B) of the second conductivity type (N-type) are formed by e.g. an ion implantation method with the intermediary of intervals (the isolation regions 23) in such a manner as to be electrically independent of the first regions 21. The second regions 22 (22A) and 22 (22B) are so formed as to have e.g. the minimum width in the design rule and have e.g. a profile of a junction depth Xj = 1300 nm and a concentration of about 8 × 10¹⁵ cm⁻³. The second regions 22 do not particularly need to be independently fabricated, but no problem arises even if they are fabricated in the same step as that of the first regions 21 depending on the case. Furthermore, in the case of contemplating a photodetector integrated circuit process, the second regions 22 may be used also for a general device. As an example, no problem arises even when a step of forming an N well and +N source/drain in an MOSFET process is used.

Subsequently, as shown in FIG. 5(3), the antireflection film 31 is formed on the semiconductor substrate 10 by using e.g. an insulating film. In the present example, a silicon nitride film having a thickness of 50 nm is formed by an LP-CVD method in contemplation of a blue laser (λ = 405 nm).

Subsequently, as shown in FIG. 6(4), the interlayer insulating film 41 and interconnects 45 are formed in a normal wiring step. The interconnects 45 and the interlayer insulating film 41 can be formed in plural layers for example. At last, an over-passivation film 44 is formed. The thickness from the surface of the antireflection film 31 to the surface of the over-passivation film 44 was set to e.g. 6.0 µm. Furthermore, a silicon oxide film (SiOₓ) was used at least in the thickness range of 1.5 µm on the antireflection film 31.

Subsequently, as shown in FIG. 6(5), etching from the over-passivation film 44 to the interlayer insulating film 41 is performed by a normal reactive ion etching (RIE) method, to thereby form the aperture 42 above the light-receiving parts. In the present example, a resist 61 for etching was used as the etching mask. By the reactive ion etching, the insulating film below the resist 61 is etched by 5.0 µm (with variation within ± 10%). As a result, the interlayer insulating film 41 with a thickness of 1.0 µm is left on the antireflection film 31.

Subsequently, as shown in FIG. 6(6), a resist film 63 having an aperture 64 inside the aperture 42 is formed by a resist coating technique, a photolithography technique, and so on.

Subsequently, the interlayer insulating film 41 that is left on the antireflection film 31 and formed of the silicon oxide film is removed by solution etching with use of an etchant based on a hydrofluoric acid, to thereby form an aperture 43 arising from extension of the aperture 42. Because the antireflection film 31 is formed of a silicon nitride film, the etching rate thereof with respect to an etchant based on a hydrofluoric acid is greatly lower than that of a silicon oxide film. Thus, the antireflection film 31 is hardly etched due to the achievement of the high selection ratio, which makes it possible to expose the surface of the antireflection film 31.

Subsequently, as shown in FIGS. 7(7) and 7(8), potentials Vc1, Vc2, and Vc3 according to need are applied to the respective first regions 21A, 21C, and 21B, respectively, exposed in the aperture 43. Thereby, the photons incident on the respective regions are drawn out from the respective electrodes so as to act as intended current signals as described above. Furthermore, the photons incident on the second regions 22A and 22B are drawn out to the power supply Vcc.

In the above-described manufacturing method, the aperture 43 formed in the interlayer insulating film 41 above the first regions 21 is matched with the size of the first region 21C in such a manner as to be continuous between apertures 43A and 43B above the first regions 21A and 21B, to thereby form an aperture 43 (43C) with small width. This aperture 43 corresponds to an aperture formed in a light-blocking film although not shown in the drawing. Due to this configuration, light incident on the periphery of the first regions 21 can be blocked. In addition, in the part of the aperture 43C, light incident on the sides of the first light-receiving parts 11 and the second light-receiving part 12 can be received by the second regions 22 and can be drawn out to a fixed potential or a reference potential. Thus, the influence of peripheral light on the first regions 21 (21A, 21B, 21C) can be greatly suppressed. In addition, because the aperture 43C is so formed as to have a size larger than that of the aperture for the conventional first region 21C, an advantage that the antireflection film 31 will not be penetrated by etching is achieved. Consequently, the antireflection film 31 have a uniform film thickness above the first regions 21A and 21B21C, and the second regions 22A and 22B, and thus can maximally exert the antireflection effect for all of these regions.

In the above-described respective embodiment examples, the concentration of the second region 22 is set to the same level as that of the first region 21. However, the concentration of the second region 22 may be higher than that of the first region 21. Increasing the concentration provides an advantage that the parasitic resistance is decreased and the lifetime of generated caps is shortened. It is preferable that the second region 22 have a concentration of e.g. about 1 × 10¹⁹ atoms/cm⁻³ or a higher concentration. Furthermore, if the junction of the second region 22 is too shallower than that of the first region 21, there is a possibility that the light that has entered a part deeper than the junction part of the second region 22 enters the first region 21 and has an adverse effect thereon. Therefore, it is preferable that the second region 22 be so formed as to have the same depth as that of the first region 21 or a larger depth.

For the above-described respective embodiment examples, the description has been made with the P-type defined as the first conductivity type and the N-type defined as the second conductivity type. However, the present invention comes into effect also when the N-type is defined as the first conductivity type and the P-type is defined as the second conductivity type.

According to the present invention relating to claim 1, light incident on the periphery of the first region can be swept out toward the fixed potential side by the second region. In addition, the size of the first region is equivalent to the size of the effective light-receiving region. Thus, an advantage is achieved that a favorable light-reception sensitivity characteristic is achieved in terms of both the limit to the light-reception sensitivity with respect to the size of the light-receiving region in the optical design and anti-stray-light measures against light incident on the outside of the light-receiving region. Furthermore, the deterioration of the crosstalk characteristic due to the influence of light incident on the separation region can be prevented.

According to the present invention relating to claim 9, an advantage is achieved that the light-receiving device of the present invention having the above-described effects can be manufactured and a light-receiving device that is excellent in the antireflection effect can be formed.

## Claims

1. A light-receiving device comprising:
a light-receiving part that is formed in a semiconductor substrate of a first conductivity type and has a first region of a second conductivity type opposite to the first conductivity type; and
a second region of the second conductivity type that is formed on at least a part of the semiconductor substrate around the light-receiving part with intermediary of an isolation region of the first conductivity type and is electrically independent of the first region, wherein
the second region is fixed to a potential independent of the first region, and
an aperture of an insulating film formed above the light-receiving part is so formed as to range from an area above the first region via an area above the isolation region to an area above a part of the second region.

2. The light-receiving device according to claim 1, wherein
a potential of the first region is defined as Vpd and a potential of the second region is defined as Vn, and an absolute value of Vpd is equal to or smaller than an absolute value of Vn.

3. The light-receiving device according to claim 1, wherein
the second region is coupled to a supply potential or a reference potential in a circuit.

4. The light-receiving device according to claim 1, wherein
the potential Vn of the second region is the same potential as the potential Vpd of the first region.

5. The light-receiving device according to claim 1, wherein
a reflectivity is constant in an area above the first region and the isolation region.

6. The light-receiving device according to claim 1, wherein
a reflectivity is constant at least in an area above the first region, a part of the second region, and the isolation region.

7. The light-receiving device according to claim 1, wherein
an impurity concentration of the second region is higher than an impurity concentration of the first region.

8. The light-receiving device according to claim 1, wherein
the first region and the second region have the same impurity concentration profile in a depth direction.

9. The light-receiving device according to claim 1, wherein
a plurality of first light-receiving parts each formed of the light-receiving part are provided, and
a second light-receiving part that is independent of and different from the plurality of first light-receiving parts is provided in the semiconductor substrate between the plurality of first light-receiving parts.

10. A method for manufacturing a light-receiving device, the method comprising:
a step of forming, in a semiconductor substrate of a first conductivity type, a plurality of first light-receiving parts each having a first region of a second conductivity type opposite to the first conductivity type, and forming a second light-receiving part that is independent of and different from the plurality of light-receiving parts in the semiconductor substrate of at least one place between the first light-receiving parts;
a step of forming a second region of the first conductivity type between the first light-receiving part and the second light-receiving part with intermediary of an isolation region;
a step of forming an antireflection film on the first light-receiving parts, the second light-receiving part, and regions that isolate the first light-receiving part and the second light-receiving part from each other;
a step of forming an insulating film on the antireflection film, and thereafter forming an aperture having a bottom at which the antireflection film is exposed in the insulating film above the first light-receiving parts and the second light-receiving part in a continuous manner; and
a step of fixing the second region to a potential independent of the first region.

11. The method for manufacturing the light-receiving device according to claim 10, wherein
the first region and the second region are formed in the same step.

12. An optical pick-up device including a light-receiving device comprising:
a light-receiving part that is formed in a semiconductor substrate of a first conductivity type and has a first region of a second conductivity type opposite to the first conductivity type; and
a second region of the second conductivity type that is formed on at least a part of the semiconductor substrate around the light-receiving part with intermediary of an isolation region of the first conductivity type and is electrically independent of the first region, wherein
the second region is fixed to a potential independent of the first region, and
an aperture of an insulating film formed above the light-receiving part is so formed as to range from an area above the first region via an area above the isolation region to an area above a part of the second region.

13. An optical disc device including a light-receiving device comprising:
a light-receiving part that is formed in a semiconductor substrate of a first conductivity type and has a first region of a second conductivity type opposite to the first conductivity type; and
a second region of the second conductivity type that is formed on at least a part of the semiconductor substrate around the light-receiving part with intermediary of an isolation region of the first conductivity type and is electrically independent of the first region, wherein
the second region is fixed to a potential independent of the first region, and
an aperture of an insulating film formed above the light-receiving part is so formed as to range from an area above the first region via an area above the isolation region to an area above a part of the second region.
